Europäisches Patentamt

European Patent Office

Office européen des brevets

(11) Publication number: **0 116 073**
**B1**

(12) **EUROPEAN PATENT SPECIFICATION**

(45) Date of publication of patent specification: **06.07.88**

(51) Int. Cl.⁴: **H 01 R 4/02**

(21) Application number: **83902619.2**

(22) Date of filing: **25.07.83**

(86) International application number:
**PCT/US83/01143**

(87) International publication number:
**WO 84/00643 16.02.84 Gazette 84/05**

(54) **SOLDER BEARING EDGE CLIP.**

(30) Priority: **29.07.82 US 402963**

(43) Date of publication of application:
**22.08.84 Bulletin 84/34**

(45) Publication of the grant of the patent:
**06.07.88 Bulletin 88/27**

(84) Designated Contracting States:
**AT BE CH DE FR GB LI LU NL SE**

(56) References cited:
**US-A-4 019 803**
**US-A-4 120 558**
**US-A-4 203 648**
**US-A-4 302 067**
**US-A-4 345 814**
**US-A-4 357 069**
**US-A-4 367 910**

(73) Proprietor: **NORTH AMERICAN SPECIALITIES CORP.**
**120-12 28th Avenue**
**Flushing New York 11354 (US)**

(72) Inventor: **SEIDLER, Jack**
**29-34 146th Street**
**Flushing, NY 11354 (US)**

(74) Representative: **Pritchard, Colin Hubert et al**
**Mathys & Squire 10 Fleet Street**
**London EC4Y 1AY (GB)**

Courier Press, Leamington Spa, England.

## Description

This invention relates to a solder bearing edge clip or connector for attachment to a contact pad on a substrate.

In assembling a substrate (chip) on which conductive paths have been deposited with connecting elements in the nature of terminal clips, it is customary to provide a small quantity of solder at each point where a connector makes contact with a "pad" on the substrate, so that a good electrical path will be established. Several specifically different ways of attaching small solder masses at the critical points are disclosed in Seidler U.S. Patents Nos. 4 120 558 and 4 203 648 and also in U.S. Patents Nos. 4 019 803 (Schell), 4 302 067 (Monson et al), 4 357 067 (Milora) and 4 345 814 (Gutbier et al). In all such prior terminal clips or connectors the means for attaching each solder mass comprises a body portion and fingers stamped out of a thin metal blank. The fingers are bent out of the plane of the body portion so as to provide a gap into which the substrate can be fitted. One or both fingers is fitted tightly around the solder or, in the case of U.S. Patent No. 4 120 558, the solder may be rivetted into a hole in the body portion. The solder is usually cut to form a small wire or cylindrical plug. The axis of the solder wire or cylinder has, uniformly, extended parallel to the plane of the flat metal blank.

With the trend toward miniaturization of the circuit-bearing substrates, it has become important to provide terminal clips which can be arranged in close lateral proximity to each other and a step in that direction is disclosed in Seidler U.S. Patent No. 4 367 910 where each terminal element is constituted by a finger which retains sufficient material to be adequately conductive and self-sustaining while being narrowed by longitudinal folding. Here, too, the solder plug axis is parallel to the plane of the folded metal.

It is an object of this invention to provide a solder bearing edge clip wherein each solder mass is held by the oppositely disposed edges of fingers cut or stamped from a flat blank.

It is a furher object of the invention to provide an array of such edge clips which can be attached to contact pads very closely spaced along the margins of a circuit-breaking substrate, the edge clips lying in parallel planes, equally closely spaced.

It is another object of the invention to provide an edge clip wherein the body of the clip is formed by stamping from a flat sheet metal and the solder wire, from which each solder mass is formed, has its axis perpendicular to the plane of said sheet metal.

According to the present invention there is provided an edge clip for securement to a contact pad on a circuit-bearing substrate, comprising a flat clip body portion of sheet metal and at least one compact mass of solder, characterised in that the body portion is provided with a pair of integral flat contact arm elements lying in the plane of the body portion, and each arm element is provided with at least one end portion which also lies in the plane of the body portion and which is adapted to engage edgewise a mass of solder.

The invention will now be described, by way of example, with reference to the accompanying drawings, in which:—

Fig. 1 represents a perspective view of a single edge clip associated with a substrate portion, shown in broken lines;

Fig. 2 represents a similar view of an array of edge clips mounted on a common bandolier;

Fig. 3 represents a transverse section on the line III—III of Fig. 1;

Fig. 4 represents a similar section showing the solder mass after melting;

Fig. 5 represents a view similar to Fig. 2 showing a first modified form of edge clip and a modified form of bandolier mounting;

Fig. 6 represents a view similar to Fig. 1 showing a second modified form of edge strip connected to a supporting strip at one end and a bandolier at the other end;

Fig. 7 represents a detail perspective view of two clip fingers with solder buttons mounted therein;

Fig. 8 represents a section on the line VIII—VIII of Fig. 7, and

Fig. 9 represents the same section as Fig. 8, before "riveting" of the solder mass.

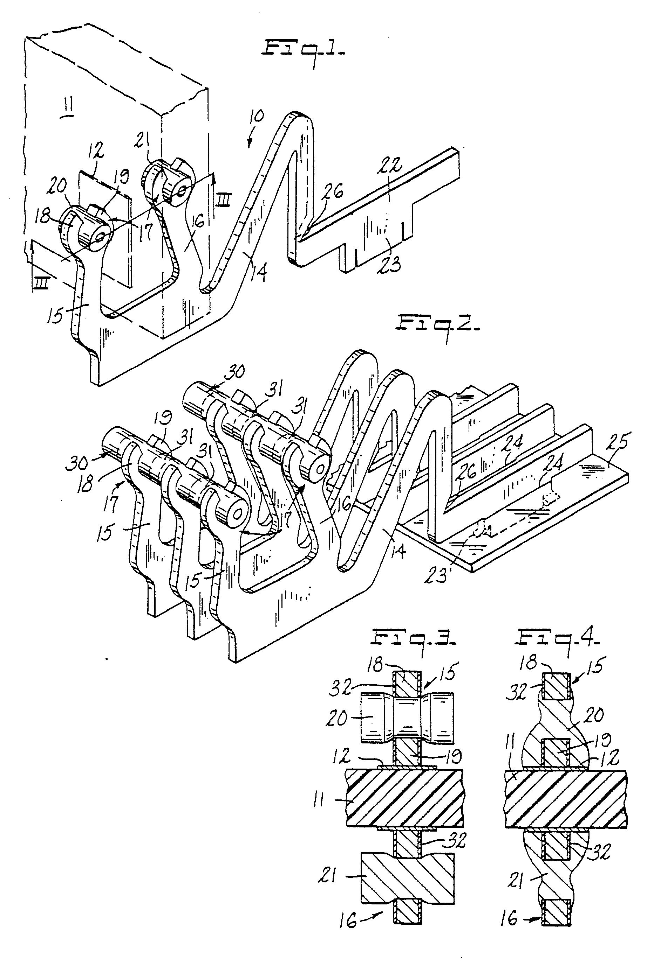

Referring to the drawings, a first form of clip 10 is shown in Figs. 1 to 4, Fig. 1 showing the relation of a single clip to an edge portion 11 of a substrate on which a contact pad 12 has been deposited. The contact pad 12 and its counterpart, if any, on the opposite face of the substrate are assumed to be terminals of an electronic circuit (not shown) deposited on the substrate and requiring connection to other circuit elements for any appropriate purpose.

The clip 10 comprises a body portion 14, shown as having a goose-neck configuration, with spaced arms 15, 16 projecting laterally in the plane of the body to provide a gap 17 which approximates the thickness of the substrate. Each arm terminates in a pair of spaced arcuate fingers 18, 19 and, in the completed clip, each pair of fingers embraces tightly a cylindrical solder mass 20, 21. At its opposite end the clip body is connected to a mounting block 22 having a depending tab 23 which can be fitted in a slot 24 of the carrying bandolier 25 and riveted in place, e.g., by upsetting the ends of the tab as shown at 23′ in Fig. 2. The connection of the clip body 14 to the block 25 is marked by a break-away notch 26, for easy removal of the bandolier and mounting blocks when a clip or an array of clips has been soldered in place on a substrate.

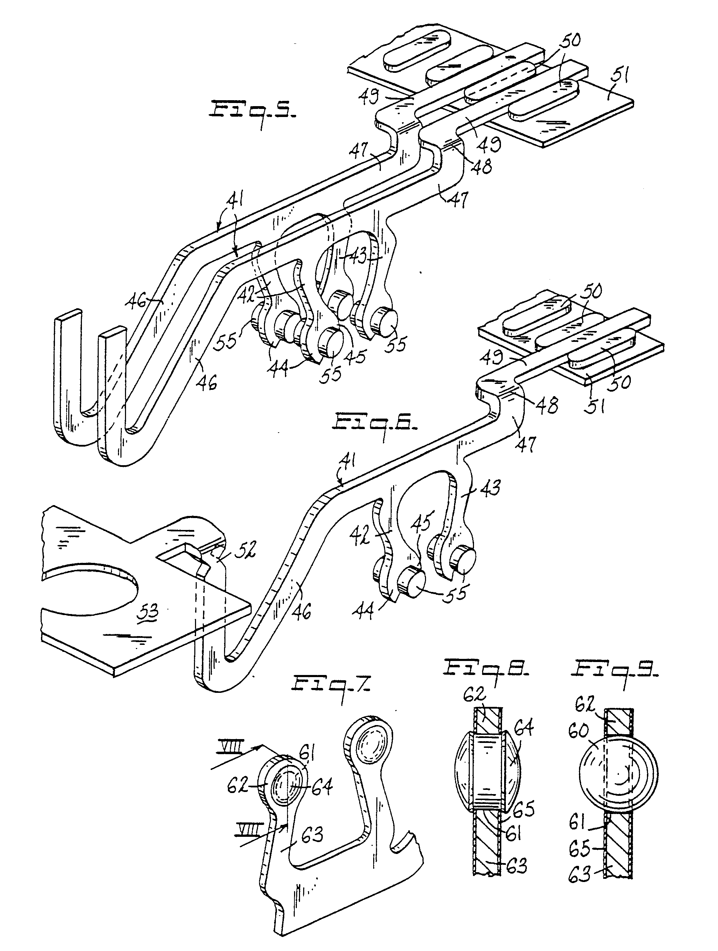

To manufacture any desired multiplicity of such clips, the blanks (as shown in Fig. 1 but with open fingers and without solder) are stamped from a strip or sheet of metal and are mounted automatically on a carrying bandolier 25. Solder wires 30 are laid between the respective fingers which are than closed tightly enough to indent the softer (lead) solder wire, as shown in Fig. 3. The wires are then cut away to remove short sections 31 and leave discrete solder masses firmly gripped between each pair of fingers. As an additional refinement, the clip faces are desirably coated with tin 32, at least in the finger areas, in order to provide a compatible path for the solder to follow, when melted, and thus assure formation of a good electrical bond with the pads on the substrate, as illustrated in Fig. 4.

A modified form of clip is shown in Figs. 5 and 6, wherein the body portion 41 is elongated and extends in opposite directions from the arms 42, 43 with fingers 44, 45 as before. In one direction the body portion is a goose-neck 46 and in the other direction it is a flat strip 47 which is integral with a stem end 49, bent through 90° at 48, and adapted to be frictionally engaged between the elongated parallel lugs 50 of a carrying bandolier 51. Because of the elongated form of the clip, it is desirable to support also the goose-neck end, as shown in Fig. 6, where a break-away connection 52 is provided between the clip and a carrying strip 53. The solder masses 55 correspond to the masses 20, 21 and are formed and attached in the same manner as described above.

An alternative form of solder mass is shown in Figs. 7, 8, and 9 as used in clips of the type shown in Figs. 1 to 6. In this alternative form the solder wire is replaced by solder spheres 60 which are inserted with a friction fit, in apertures 61 formed in the enlarged end portions 62 of contact arms 63, corresponding to arms 15, 16, 42 and 43. After insertion the spherical masses (Fig. 9) are upset as shown in Fig. 8 to achieve a two-way mushroom configuration 64 whereby they are very firmly retained in the clip. The contact arm surfaces may be provided with a tin coating 65, for solder flow assistance as mentioned above.

In the form shown in Figs. 1 to 4 the maximum thickness of the clip, before assembly with a circuit chip, is only the length of the solder mass, and this could be reduced by using solder balls as shown in Figs. 7, 8 and 9. That is, the body of the clip is a flat sheet, in a single plane, which permits assembling the clips with a very close pitch, as now frequently required or desired. In the modified clip of Figs. 5 and 6 the over-all width is slightly greater due to the bending of the stem end into a different plane but a relatively close pitch can still be attained since the stem is straight and narrow.

## Claims

1. An edge clip for securement to a contact pad (12) on a circuit-bearing substrate (11), comprising a flat clip body portion (14) of sheet metal and at least one compact mass of solder (20, 21), characterised in that the body portion (14) is provided with a pair of integral flat contact arm elements (15, 16) lying in the plane of the body portion, and each arm element is provided with at least one end portion (18, 19, 62) which also lies in the plane of the body portion and which is adapted to engage edgewise a mass of solder (20, 21).

2. An edge clip according to claim 1, characterised in that the contact arm elements (15, 16) project from the clip body portion (14) in positions which define, between each pair of said elements, a gap (17) adapted to receive an edge of a circuit-bearing substrate (11).

3. An edge clip according to claim 1, characterised in that each end portion (18, 19) comprises a pair of arcuately shaped fingers (18, 19).

4. An edge clip according to claim 1, characterised in that the edges of the fingers indent the engaged solder mass (20, 21).

5. An edge clip according to claim 1, characterised in that the solder mass (20, 21) is cylindrical and has its axis disposed perpendicularly to the plane of the body portion (14).

6. An edge clip according to claim 1, characterised in that the or each end portion (62) comprises an integral flat element (63) in which is formed an opening (61) and the mass of solder (64) is spherical and fitted in said opening.

7. An edge clip according to claim 6, characterised in that the mass of solder (64) is expanded to engage the margins of said opening.

8. An array of spaced edge clips as in any one of the preceding claims 1 to 7, characterised by a bandolier (25) for supporting said clips at one end in substantially parallel and equally spaced arrangement.

9. A method of making an edge clip according to any one of the preceding claims characterised by the steps of stamping the body portion, the contact arm elements and the end portion from a strip or sheet of metal, and then engaging the end portion with a mass of solder.

10. A method according to claim 9, characterised by stamping each end portion as a pair of arcuately shaped fingers with the further step of closing each pair of fingers tightly enough to indent the mass of solder therebetween.

## Patentansprüche

1. Randklemme für die Befestigung an einem Kontaktfleck (12) auf einem eine Schaltung tragenden Substrat (11), bestehend aus einem flachen Klemmenkörperteil (14) aus Metallblech und wenigstens einer kompakten Lotmasse (20, 21), dadurch gekennzeichnet, daß der Körperteil (14) mit einem Paar integraler flacher Kontaktarmelemente (15, 16) versehen ist, die in der Ebene des Körperteils liegen, und daß jedes Armelement mit wenigstens einem Endabschnitt (18, 19, 62) versehen ist, der ebenfalls in der Ebene des Körperteils liegt und der dazu eingerichtet ist, am Rand mit einer Lotmasse (20, 21) zu gelangen.

2. Randklemme nach Anspruch 1, dadurch gekennzeichnet, daß die Kontaktarmelemente (15, 16) von dem Klemmenkörperteil (14) an Stellen vorstehen, die zwischen jedem Paar der genannten Elemente einen Spalt (14) ausbilden, der dazu eingerichtet ist, einen Rand eines eine Schaltung tragenden Substrats (11) aufzunehmen.

3. Randklemme nach Anspruch 1, dadurch gekennzeichnet, daß jeder Endabschnitt (18, 19) ein Paar bogenförmiger Finger enthält.

4. Randklemme nach Anspruch 1, dadurch gekennzeichnet, daß die Ränder der Finger in die angeschlossene Lotmasse (20, 21) eindrücken.

5. Randklemme nach Anspruch 1, dadurch gekennzeichnet, daß die Lotmasse (20, 21) zylindrisch ist und mit ihrer Achse senkrecht zur Ebene des Körperteils (14) angeordnet ist.

6. Randklemme nach Anspruch 1, dadurch gekennzeichnet, daß der oder jeder Endabschnitt (62) ein integrales flaches Element (63) aufweist, in dem eine Öffnung (61) ausgebildet ist, und daß die Lotmasse (64) sphärisch ist und in die genannte Öffnung eingepaßt ist.

7. Randklemme nach Anspruch 6, dadurch gekennzeichnet, daß die Lotmasse (64) expandiert ist, um die Ränder der genannten Öffnung zu ergreifen.

8. Gruppe aus im Abstand angeordneter Randklemmen nach einem der vorhergehenden Ansprüche 1 bis 7, gekennzeichnet durch ein Band (25) zum Halten der Klemmen an einem Ende in einer im wesentlichen parallelen und gleichmäßig beabstandeten Anordnung.

9. Verfahren zum Herstellen einer Randklemme nach einem der vorhergehenden Ansprüche, gekennzeichnet durch die Schritte: Ausstanzen des Körperteils, der Kontaktarmelemente und des Endabschnitts aus einem Metallstreifen oder — blech und anschließendes Ineingriffbringen des Endabschnitts mit einer Lotmasse.

10. Verfahren nach Anspruch 9, gekennzeichnet durch: Stanzen eines jeden Endabschnitts als ein Paar bogenförmiger Finger mit dem weiteren Schritt des Schließens eines jeden Fingerpaares ausreichend fest, um in die Lotmasse dazwischen einzudrücken.

**Revendications**

1. Attache de bord pour fixation à un plot de contact (12) sur un substrat (11) portant un circuit, qui comprend un corps d'attache plat (14) en feuille de métal et au moins une masse compacte de matière de soudage (20, 21), caractérisé en ce que le corps (14) comporte deux éléments de bras de contact (15, 16) plats, solidaires et disposés dans le plan du corps, et en ce que chaque élément de bras comporte au moins une partie d'extrémité (18, 19, 62) qui est également disposée dans le plan du corps et qui est prévue pour venir en contact par la tranche avec une masse de matière de soudage (20, 21).

2. Attache de bord suivant la revendication 1, caractérisé en ce que les éléments de bras de contact (15, 16) font saillie à partir du corps (14) de l'attache dans des positions qui définissent, entre chaque paire de dits éléments, un intervalle (17) prévu pour recevoir un bord d'un substrat (11) portant un circuit.

3. Attache de bord suivant la revendication 1, caractérisée en ce que chaque partie d'extrémité (18, 19) comprend deux doigts de forme courbe (18, 19).

4. Attache de bord suivant la revendication 1, caractérisée en ce que les bords des doigts mordent dans la masse de matière de soudage (20, 21) avec laquelle ils sont en contact.

5. Attache de bord suivant la revendication 1, caractérisée en ce que la masse de matière de soudage (20, 21) est cylindrique et son axe est disposé perpendiculairement au plan du corps (14).

6. Attache de bord suivant la revendication 1, caractérisée en ce que la ou chaque partie d'extrémité (62) comprend un élément plat solidaire (63) dans lequel est ménagé un orifice (61), et la masse de matière de soudage (64) est sphérique et fixée dans ledit orifice.

7. Attache de bord suivant la revendication 6, caractérisée en ce que la masse de matière de soudage (64) est élargie de manière à venir en contact avec les bords dudit orifice.

8. Ensemble d'attaches de bord espacées suivant l'une quelconque des revendications précédentes 1 à 7, caractérisé en ce qu'il comprend une bande (25) pour supporter lesdites attaches à une de leurs extrémités, sensiblement parallèlement et à égale distance les unes des autres.

9. Procédé de fabrication d'une attache de bord suivant l'une quelconque des revendications précédentes, caractérisé en ce qu'il comprend les opérations d'estampage du corps, des éléments de bras de contact et de la partie d'extrémité, dans une bande ou feuille de métal, puis d'engagement de la partie d'extrémité sur une masse de matière de soudage.

10. Procédé suivant la revendication 9, caractérisé par l'estampage de chaque partie d'extrémité sous la forme d'une paire de doigts courbes, avec en outre l'opération de fermeture de chaque paire de doigts de façon assez serrée pour mordre dans la masse de matière de soudage placée entre les doigts.

Fig.1.

Fig.2.

Fig.3. Fig.4.

Fig.5.

Fig.6.

Fig.7.

Fig.8.

Fig.9.